# EUROPEAN PATENT APPLICATION

(11) **EP 1 577 917 A1**
(43) Date of publication of application: **21.09.2005**
(21) Application number: 05012152.4
(22) Date of filing: 24.01.2000
(51) Int. Cl.: H01H 13/70, H03M 11/08

(54) **Keyboards with both individual and combination key output**

(62) Divisional of application: 00908377.5
(71) Applicant: Levy, David H., Cambridge, MA 02140 (US)
(72) Inventor: Levy, David H., Cambridge, MA 02140 (US)
(74) Representative: Müller-Boré & Partner Patentanwälte

(57) **Abstract**

The present inventions relates to a method for increasing the speed of response and the accuracy of output in an IACK keypad system, the method comprising:
scanning a matrix to determine if any keys have been activated;
upon detecting activation of a key, identifying a provisional independent key output;
continuing to scan for key activation; and,
upon detecting activation of a diagonally adjacent key prior to determining that all switches have cleared, determining an intended combination key, overriding the provisional output and outputting the intended combination key.

## Description

### Field of the Invention

This invention relates to tiled keyboards with keys smaller than the adult human finger that provide unique outputs as a consequence of both individual keys and with the actuation of adjacent keys associated with an interstice

### Background of the Invention

Miniaturization is a central paradigm in the advance of technology. A second paradigm of technologic advance is the continual increase in the complexity of products, which is, in turn, associated with the need for an increase in the number of buttons. These two fundamental paradigms are in opposition, suggesting that as time progresses, the need for smaller (yet useful) input devices will increase as overall product size decreases and the demand for additional functionality continues to rise. While voice technologies will certainly one day offer high-quality, low-cost, near-zero-size input, it is clear that such technology will always be inappropriate for use in such common instances as: a classroom, a meeting, while in mass transit (air or land), a library, etc. Therefore, to provide a continued path for these fundamental technologic advance curves, it is extremely desirable to manufacture low-cost keyboards with both maximal output density and maximal ease of use. Maximal output density means: the most single-touch operations in the smallest space. Maximal ease-of use means primarily two things: 1) Each output must be easily operated as quickly as a user may want without accidentally actuating an adjacent output and 2) in order to be intuitive and natural, the technique for actuating the output should be based on the universally known and accepted "button" paradigms, including use patterns and feel.

The density issue was well-addressed by US patent 5,612,690 to Levy, but did not address ease-of-use issues. Pertinent prior art includes US Patents #4,549,279 and 4,994,992 to Lapeyre. In These patent provide a large number of one-touch accessible operations (4MN-2M-2n+1 in an area of M x N adult human finger widths) by pressing at the adjacent edge, centers, or intersections of full sized keys. US Patent 4,400, 593 to Kunz provides the same density using miniaturized tiled keys, however with keys too small to allow edge key operation. US Patent #5,612,690 provides a significant advance to the above mentioned patents by introducing a "volcano" structure to the centers of reduced size keys and substantially increasing the maximal output density to 8MN-4m-4n+1. However, none of these patents discuss the significant and non-obvious barriers to successful implementation of either tiled keyboards, or of keyboards with both individual and combination key outputs.

For example, it is relatively trivial to implement a keyed device that operates only with individual keys, OR only with keys in combination. However, it is very difficult to implement a device that operates quickly and reliably both with individual keys and with keys in combination. To scan for only keys in combination is relatively trivial because reliable output may be determined whenever two opposing keys are registered using well-understood solutions to key switch debounce. However, when the device also outputs individual keys, there is an inherent tension between the desire to provide fast individual key operation and reliable combination key operation. Reason: In order to increase the reliability of combination keys, the time delay to wait for the appearance of all opposing keys in combination must be increased. This increase slows operation of the individual keys. The instant invention addresses this problem to provide fast individual key operation AND reliable combination key operation.

At issue therefore are the factors which elevate IACK keyboards to the standards people have come to expect from non-tiled and/or independently keyed keyboards. It is desirable for IACK keyboards to provide:
- Fast output response without degradation of the output accuracy.
- user feedback with an elastomeric keyboard: The button paradigm includes certain well-accepted tactile properties, such as deflection of the key during operation, over-travel, and feedback upon actuation, most notably a snap action at key actuation.
- A rigid key implementation.
- Backlightability.
- the provision of individually motile keys in a single elastomeric unit.
- means for combination keys to operate with small objects, such as a pencil eraser.
- Increased stroke length: It is desirable to provide an increased stroke length in a tiled molded elastomer keyboards in both units that have and do not have snap action keys, without decreasing the durometer of the material or increasing the actuation force.
- Reduced actuation force: It is desirable to provide a reduced actuation force in tiled molded elastomer keyboards in both units that have and do not have snap action keys, without decreasing the durometer of the material or decreasing the stroke length.

It is also desirable to address manufacturing issues such as:
- Providing the above functionality so that it can be manufactured, manufactured at low cost, and durable under normal conditions of consumer use.
- Integration of electronic componentry: In the quest for maximal miniaturization in the width, height and thickness of a product, it is desirable for the input device, (which will ultimately be the determinant of product size) to enable further miniaturization and/or cost reduction by enabling greater integration of electronic components.
- Two factors (namely the miniaturization of each key by a factor of four and/or the tiled nature of the device) combine to disallow the possibility of merely miniaturizing existing keyboard technologies. For example: miniaturizing existing hard plastic key cap technologies by a factor of four would yield high-tolerance, expensive, fragile and difficult-to-assemble devices; miniaturizing existing elastomeric keyboard technologies would yield a keyboard with unacceptably large gaps between adjacent keys because the snap action features themselves cannot be miniaturized without reducing the stroke of the key and/or reducing the number of cycles that may be provided.

### Summary of the Invention

In this invention the above limitations are overcome and objects and advantages achieved with embodiments that include snap action (force feedback) key caps, autonomously moving rigid plastic keycaps, elastomer with continuous surfaces that provide low-force motion, PCB area augmentation, and output control algorithms. All embodiments are within the field of miniaturized tiled IACK keyboards. Geometric details that enable a miniaturized, tiled keyboard with interstitial outputs are also described.

### Snap Action, Independent Keycaps

While a continuous planar elastomeric sheet can provide the aforementioned advantages as disclosed above, they cannot provide tactile feedback in an IACK keyboard. Non-tiled prior art elastomeric keyboards provide a tactile feel to the keys by molding a thinned annular chamfer at the base of the key. As the key is depressed, the key extends within the circumference chamfered region and as the chamfer deforms, the keys passes an "over center" point where the force is noticeably reduced approximately as the key switch makes contact. In all cases the annular chamfer is distal to the key cap surface, as viewed from above. This approach provides a high-quality of feedback for a very low cost, however, the method is highly undesirable in a elastomeric tiled keyboard because the keys are intended to be adjacent to each other, resulting in a relatively large gap between adjacent keys. To provide tactile feedback internally molded within a tiled keyboard, a new structure is here introduced. The preferred embodiment places the thinned chamfered (or radiused) region below (not distal to) the key upon which it acts. Another embodiment is to provide an array of support profiles that extends from the elastomer underside to the PCB surface as a set of parallel lines, the angle between the profile and the PCB alternating between approximately +45% and -45%. A dual durometer elastomer may be used to protect this circuity, as described above.

Manufacturing such a keyboard requires a new approach for tooling as a traditional two piece mold would not allow the part to be removed. For this device, the tooling is augmented with an alternating internal core. By removing the internal core first, deformation of the material allows the part to be removed from the tool. In another embodiment of the tooling, the third part of the tooling is withdrawn from the side of the newly formed keyboard. The same approach may be used to provide round snap action features on square keys.

### Autonomous Rigid Plastic Keycaps

Rigid plastic keycaps are desirable due to their durable quality both with respect to use and to printability during manufacture. In one embodiment a rigid plastic key is used that is highly asymmetric in the plan view: An interstitial pad is molded at one corner of each individual key cap, thereby making each physical keycap contain the legends for both individual and interstitial keys. The remaining three corners include indentations to accommodate the interstitial pad belonging to the adjacent key. Because the keys are smaller than the human finger, it is not possible to see the abnormal operation as the interstitial pads move, even when individual keys are operated. The result is therefore to deceive the user into believing that interstitial keys have physical autonomy. To maintain maximal proximity of adjacent keys and yet provide maximal distance during displacement as the keys tilt slightly as they are depressed, the skirts at the edge of keys are angled inward, rather than outward as on traditional keys.

In another embodiment, the interstitial pads are comprised of immobile posts with a height slightly less than the lowermost surface of the individual keys. These posts again provide an artificial key cap onto which interstitial legends are printed. And again, while the posts are immobile with respect to the keyboard PCB top surface, it is undetectable to the user, as their finger completely covers the interstitial keys during use and because the associated keys are motile, the user is provided the impression that the interstitial keys are also motile. In one embodiment crossmembers connect the immobile posts. All the central posts (and crossmembers) may be formed from a single piece of plastic. The keyboard may be backlit by forming this single piece from a clear material, as there are no switch mechanisms to obscure light transmission. Molded indentations, angled to provide total internal reflection, a mirrored back surface, or a series of integrally molded lightpipes to redirect light that originates from a source directed in the plane of the keyboard. Undercuts molded into the posts provide means to retain autonomous individual keycaps in a tiled configuration or to retain a single elastomeric sheet, less the combination key identification regions. In the case of the rigid plastic keycaps, a non-cosmetic elastomeric sheet underneath the individual keys is used to provide both conductive pucks at the switch locations and the spring force required to oppose finger during key actuation. The sheet may be manufactured independently from the keys or integrally molded with them. Open areas in the post part provide means for individual plastic keys to activate switches on printed circuit board below. Alternately, metallic or plastic snap domes may be used for key switch actuation. Keys may be assembled into the plane of the undercuts by bending the sheet around a form, thereby splaying the posts. Traditional snap-action tactile feedback elastomer techniques may be used in this embodiment because the elastomer is not a cosmetic part. (This issue will be elaborated later.) Crossmembers and/or immobile posts may be adhered to the PCB. The posts may also be individually
disposed directly onto keyboard PCB top surface.

### Elastomer with Continuous Surface

To provide key actuation with minimal opposition force, one embodiment includes an additional flange at approximately right angle to the plane of the elastomer. Using this structure each key may depress while experiencing deformation other than placing the elastomer in tension. The flange acts a beam that may deform towards the key center as it is depressed. This structure provides a lower requirement for actuation force than required by elastomeric keycaps which depress only through tension deformation of the sheet, thereby allowing a higher durometer material to be used with the same force requirement for key actuation.

In another embodiment, two different hardnesses of material are used to provide both a durable print surface and low-force actuation in a tiled continuous elastomer keyboard. The harder material also provides the structural integrity to maintain physical separation between the underside of the keyboard surface and any electronic componentry placed on the upper surface of the printed circuit board in the instance when high forces are placed onto the keyboard surface. To provide tactile feedback, metal or plastic snap action domes may be added beneath elastomer and/or integrated within the conductive pucks. Also, an elastomeric sheet, as described, less the areas for combination key legends may be used in combination with pad of immobile posts, described above.

### PCB Area Augmentation

The tiled miniaturized keyboard described can be adapted to allow up to 80% of the top surface of the printed circuit board supporting the keyboard to be used for electrical components. This benefit may be realized by the ability to utilize larger and hence less expensive electronic componentry, eliminating the need for a second PCB elsewhere in the product to provide the necessary board area, allowing less chip integration. Also significant is the elimination of the need connections to be made to an additional printed circuit board, as it is well-known that interconnections are a common source of product failure.

A non-conductive conformal coating is used to provide additional structural integrity to the electronic componentry. A conductive layer may be added to the conformal layer or disposed onto the inner surface of the elastomer to provide EMF/RFI shielding. In another embodiment, the elastomeric material is itself rendered conductive by doping the material with a conductive particulate or powder.

### Output Selection Algorithms

There are two sources of time delay in tiled keys with interstitial output. The first is traditional switch bounce. This is well-known in the art. The second is the variations in activation time of different keys through the stroke of a combination key. These two delays, when superimposed, result in a noticeably reduced output rate (slow performance) to maintain reliable output. Variously, the rate may be increased at a cost of diminished reliability. Therefore, embodiments are presented that offer both high reliability and fast response.

One embodiment includes a device-level debounce that addresses the noise associated with the operation of keys in combination in miniaturized tiled keyboards. It can briefly be described as designing the electronics and software to designate a default output based on initial readings, then reading and disregarding a predetermined number of erroneous inputs before accepting the erroneous characters as a new base, or outputting the currently accepted default output. In one embodiment, an artificial delay is added between initial switch recognition by the keyboard and feedback to the user (on the order of 30 microseconds). This delay allows the finger motion to continue unabated after a first switch recognition, thereby increasing the chance of a second intended switch contact occurring before the user retracts finger in preparation for touching a different key. The advantages of this embodiment are more pronounced during extremely slow or light contact by the user. It is also advantageous to implement a dynamic "learn mode" that varies the delays as a function of user input. Under the assumption that the delete key indicates errant input, the length of these delays are reassigned accordingly. For example: use of the delete key immediately following an individual output and subsequently reading an associated combination output indicates that the number of consistent measurements and/or delay time should be increased. Additional levels of detail for a learn mode are described.

One embodiment includes a two-layer scan and correction algorithm to maximize speed of key actuation while minimizing degradation of output reliability. It provides user feedback (visual on the display and/or tactile in the form of a "beep") after determining a valid output option and then continues to scan afterwards, in preparation for modifying the original (provisional) output as a function of switch data acquired after the output has been made.

The preferred embodiment includes a variable timing criterion for determination of intended individual key actuations in which the timing criterion is established by the character of key attack. For example, the amount of time required for the device to determine that an individual key was intended by the user may vary as a function of the resistance measured at that key switch during the stroke. Low resistivities correlate with short time requirements and high resistivities correlate with long time requirements. The electronics for this embodiment includes a resistance threshold measurement means monitoring the keyboard switch matrix.

### Electronic Hardware

To provide for reliable operation with small objects such a pencil eraser, an additional 2N-1 matrix lines are added to each axis of the previously disclosed matrix of N x N. These scan lines monitor additional switches located at the interstices of combination keys, thereby providing a system that works reliably with both large fingers and small objects, such as pencil erasers.

In another embodiment each key switch is in direct communication with the microprocessor. One side of each switch in the matrix is tied to a common electrical potential. This allows the entire keyboard to be imaged simultaneously, providing an accurate time history of each individual switch during the actuation of a combination key.

All these embodiments may be used alone or in combination.

### Brief Description of the Drawings

FIG. 1a shows a top view of rigid plastic tiled keycap with severe asymmetry.
FIG. 1b shows a side view of rigid plastic tiled keycap with severe asymmetry..
FIG. 2 shows rigid plastic keys in a matrix.
FIG. 3a shows a rigid plastic tiled keycap with the interstitial pads comprised of immobile posts attached to a base layer. FIG. 3B shows rigid plastic tiled keycap with the interstitial pads comprised of immobile posts with crossmembers. FIG. 3c shows a cross section thru part of FIG 3b.
FIG. 4 shows how rigid plastic tiled keycaps may be assembled into the plane of the undercuts by plastically deforming the base layer around a form.
FIG. 5 shows a molded one piece continuous elastomeric tiled keyboard with a stress relief mechanism at the surface.
FIG. 6 shows a prior art keyboard.
FIG. 7a shows a molded one piece continuous elastomeric tiled keyboard with highdurometer key centers.
FIG. 7b shows a cross section of a design that allows operation with smaller fingers and pencil erasers.
FIG. 8 shows a molded one piece continuous elastomeric tiled keyboard with an embodiment of snap action feature.
FIG. 9 shows the tooling necessary to provide the snap action feature of FIG. 7.
FIG. 10 shows a molded one piece continuous elastomeric tiled keyboard with individually motile keys and snap action tactile feedback.
FIG. 11 shows molded one piece continuous elastomeric tiled keyboard with individually motile keys and tactile feedback in which nearly the entire surface is made of a hard plastic material.
FIG. 12 shows a hard surface tiled keyboard integrally molded with an elastomer to constrain the keys.
FIG. 13 shows a molded one piece continuous elastomeric tiled keyboard with individually motile keys and tactile feedback in which nearly the entire surface is made of a hard plastic material with geometrically controlled key actuation.
FIG. 14 shows the top surface of a printed circuit board populated with electronic components in addition to supporting keyboard operation.
FIG. 15 shows a lightpipe for tiled keyboards with interstitial keys
FIG. 16 shows the preferred algorithm for determining key actuation in a tiled keyboard with interstitial keys.
FIG. 17 shows a scanning algorithm with a device-level debounce.
FIG. 18 shows detail of the device-level debounce algorithm.
FIG. 19 shows miniaturized tiled keys with interstitial output.
FIG. 20 shows a cross section of a finger during operation on the most basic elastomeric embodiment to further demonstrate the requirements for non-ambiguous operation of a single key in an IACK keyboard.
FIG. 21 a perspective view of the subject matter of FIG. 13.
FIG. 22 shows the logic diagram for differentiating intended individual key output from combination key output as a function of key attack characteristic.
FIG. 23 shows an electrical schematic associated with the logic diagram of FIG. 1.
FIG. 24 shows example values that may used to implement the electronics of FIG. 2.
FIG. 25a shows the back side of an elastomeric keyboard with both individual and combination keys and switch conductors disposed at each location.
FIG. 25b shows an IACK printed circuit board with both individual and combination key switch contacts.
FIG. 25c shows first switch matrix and second switch matrix.
FIG. 26 shows a contact matrix in which one side of each switch is held at a common potential.
FIG. 27 shows the interface surface of an elastomeric implementation of an IACK keyboard.
FIG. 28 shows a printed circuit board with interstitial and individual key switch halves, used to interface with an elastomer with a conductive under surface.
FIG. 29 shows a cross section of another embodiment of molded one piece continuous elastomeric tiled keyboard with individually motile keys and tactile feedback keys.

### Detailed Description

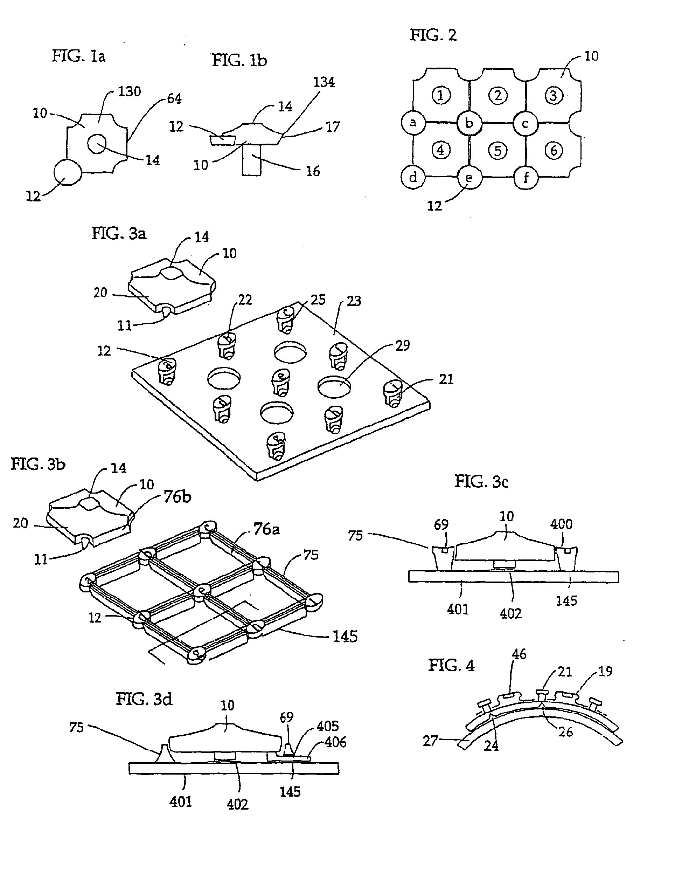

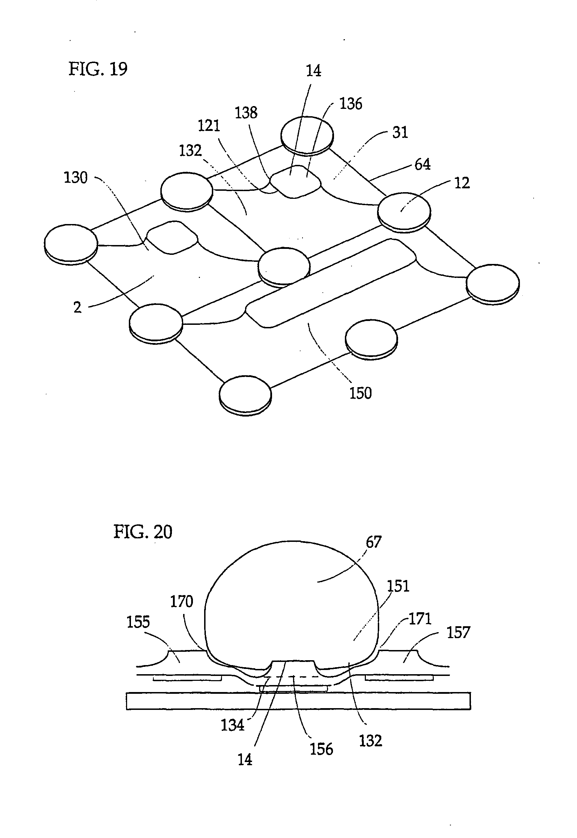

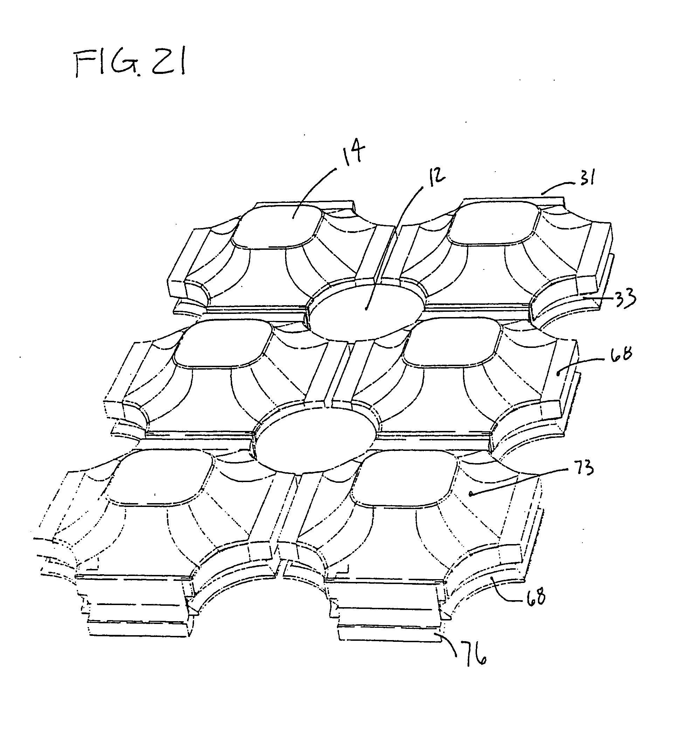

FIG. **1a** shows a top view of rigid plastic tiled keycap **10** with interstitial pad **12** integrally molded at one corner. FIG. **1b** shows a side view of rigid plastic tiled keycap **10** with elevated central pad **14** located over rod **16.** Rod **16** may be located more centrally between interstitial pad **12** and elevated central pad **14.** Reverse bevel **17** provides an undercut at the periphery **64** of rigid plastic tiled keycap **10** to minimize contact with adjacent keys as a consequence of misalignment or tilting during operation. Details of the geometry between elevated central pad **14** and periphery **64** are provided in FIGS 19 and 20. FIG. 2 shows a plurality of rigid plastic tiled keycaps **10** in a matrix. In one embodiment the interstitial pad **12** both provides a surface to indentify combination key output and to retain rigid plastic tiled keycaps **10,** as shown in FIG 3a.

FIG. 3a shows a rigid plastic tiled keycap **10** with the interstitial pads **12** at the tops of posts **21.** These posts **21** provide an artificial key cap onto which interstitial legends **22** are printed. Despite the fact that the posts **21** of this embodiment are immobile, the immobility is undetectable to the user as their finger completely covers the interstitial pads **12** during use and because the associated rigid plastic tiled keycaps **10** are motile. The user therefore receives the impression that the interstitial (combination) keys are also motile. In this embodiment the posts **21** are formed from a single piece of plastic **23.** Undercuts **25** molded into the posts **21** provide means to retain autonomous rigid plastic tiled keycaps **10** in a tiled configuration. Prongs **11** fit into undercuts **25,** restraining rigid plastic tiled keycaps **10.** Two prongs **11** are shown symmetric about elevated central pad **14,** although a larger number can be used. Open areas **29** in the single piece of plastic **23** provide means for rigid plastic tiled keycaps **10** to activate switches on PCB below (not shown) using switch means known in the art. FIG. 3b shows a rigid plastic tiled keycap **10** with the interstitial pads **12** at the tops of posts **21** at a height slightly lower than keycap lower surface **20** with crossbeams **75.** In this embodiment crossbeams **75** have angled bezels **76a** (angled interior to the kay as opposed to that of the embodiment of FIG 1) that correspond with angled bezels **76b.** FIG. 3C shows a cross section through FIG. 3b as indicated. In this embodiment,rigid plastic tiled keycaps **10** are bound by crossbeams **75** with gap **69** integrally molded and gap edges **400** mimicing the contour of the upper surface of the key cap. PCB **401** sits directly beneath. The underside **145** of crossbeams **75** may be adhered to the PCB below. Snap dome **402** completes electrical connection when key is pressed. FIG. 3d shows crossbeams **75** with a primarily inverted funnel shape. Gap **69** is minimally presented at the surface and a substantially larger cross section lays below with a corresponding comntour in the edge of rigid plastic tiled keycap **10.** Web member **406** connects each keycap **10** together. Internal opening **405** allows web member **406** to penetrate crossbeams **75** alllowing the entire keypad assembly to consist of two pieces. Keycaps **10** are retained by interstitial pads **12.**

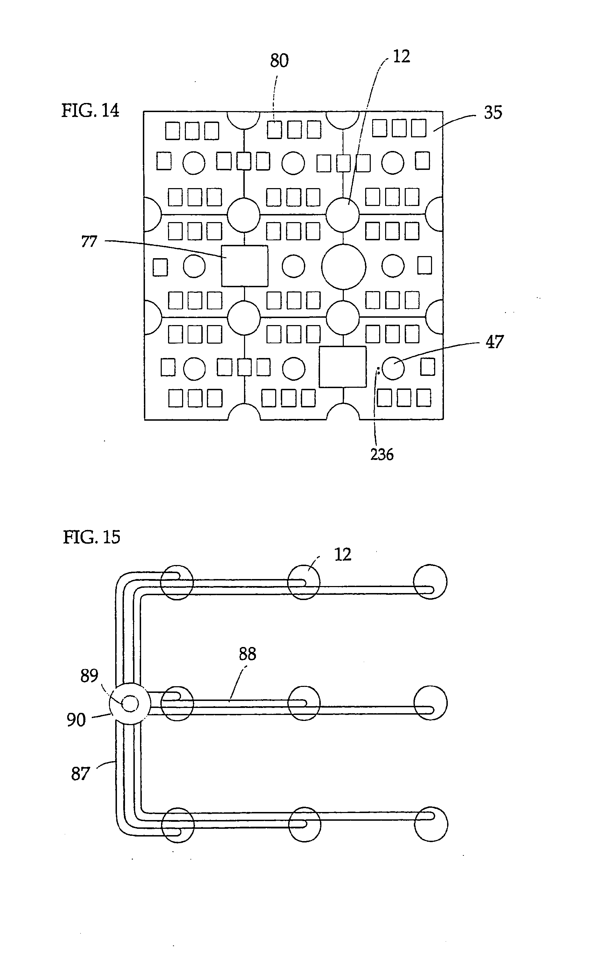

FIG. 4 shows how rigid plastic tiled keycaps **10** may be assembled into the plane defined by undercuts **25** by bending the single piece of plastic **23** around a form **27,** thereby splaying the posts **21.** (Alternately, they may be snapped in place.) An elastomeric sheet **19,** that lay underneath the individual keys provide both conductors **46** at the switch locations and the spring force required to oppose finger during normal operation. The elastomeric sheet **19** may be manufactured independently from the rigid plastic tiled keycaps **10** or integrally molded with them. Traditional snap-action tactile feedback elastomer techniques may be used in the instance in which the elastomeric sheet **19** is molded independently from the rigid plastic tiled keycaps **10,** thereby allowing the snap action feature to reside beneath, rather than at the periphery of tiled keycaps **10.** The keyboard may be backlit by forming the single piece of plastic **23** from a optically transmissive material. The absence of switch mechanisms provides a high degree of light transmission. Molded indentations **24** may be used to provide total internal reflection, or a mirrored back surface **26** to redirect light that originates from a source directed in the plane of the keyboard. Variously, the single piece of plastic **23** may be comprised of individual light pipes that provide light to each post **21** (FIG. 15).

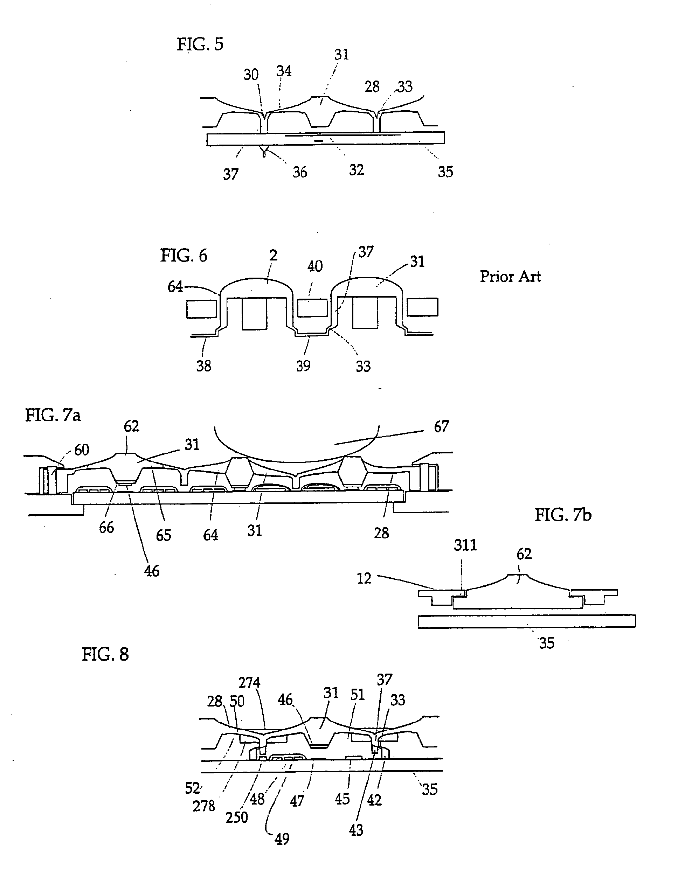

FIG. 5 shows a molded one piece continuous elastomeric tiled keyboard with beam relief **30.** As the generic key **31** is depressed toward capacitive switch matrix **32,** beam relief **30** reduces the actuation force required from molded elastomer **28** of a given thickness by providing material in bending, rather than in tension. Beam relief **30** may also provide a snap-action tactile feature **33** by being placed at the surface **34,** at the top of upright **37,** rather than the base as with prior art keyboards. Capacitive switch matrix **32** comprises an intersecting matrix of traces buried within printed circuit board **35.** Hold down **36** retains keyboard to surface of printed circuit board **35.** One piece construction reduces costs.

FIG. 6 shows a typical prior art keyboard **38.** Snap-action tactile feature **33** is at the base of the keyboard **38,** below upright **37** and distal to the periphery **64.** Hidden area **39** lies below housing **40** through which key **31** protrudes. Housing **40** separates adjacent keys 2.

FIG. 7a shows a molded one piece continuous elastomeric tiled keyboard with at least two durometers. The molded elastomer **28** is held lightly in tension by pins **60.** A high durometer material (75-90) is used for the center **62** of key **31,** while the lower surface **20** of the key **31** is made with a low durometer material such as 40-50. The leftmost key is shown with the high durometer material as wings **65,** extending approximately half way to the edge of generic key **31.** The purpose of these high durometer wings **65** is to increase the effectiveness for small objects, such as pencil erasers, without requiring additional switches at interstices (a goal which can otherwise be accomplished as shown in FIG 7b, with shelves **311** between the interstitial pads **12** and center **62** that overlap such that downward motion of center **62** does not affect interstitial pad **12,** but downward motion of interstitial pads **12** does affect center **62.)** A low durometer pad **66** sits between and/or incorporated within conductor **46** to provide compliance at the switch interface. Finger **67** is shown pressing a combination (interstitial) key.

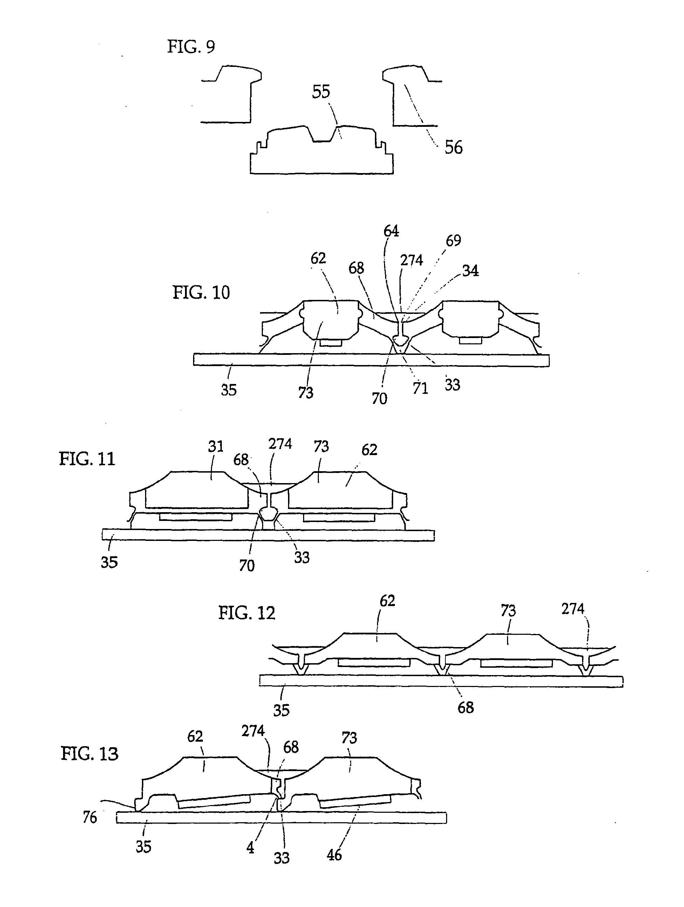

FIG. 8 shows a molded one piece continuous elastomeric tiled keyboard with alternating snap action feature **42.** Alternating snap action feature **42** provides keys **31** with snap-action tactile feature **33** that alternate between being underneath and not underneath adjacent keys. Stop **43** provides an end of stroke for the upper portion of upright **37.** Stop **43** provides additional protection of any electronic components **45** that may be located on top of printed circuit board **35.** Conformal coat **48** also protects electronic components **45.** Conductive layer **49** may be coated over conformal coat **48** or on underside **50** of molded elastomer **28.** Conductor **46** activates switch **47** when key **31** is depressed. Alternating snap action feature **42** is manufacturable due to a two-piece female cavity shown in FIG. 9. Referencing FIGS 8 and 9, first portion **55** rests within first areas **51** and a second portion **56** lies in alternating second areas **52.** Prior art keyboards do not require a two-piece female cavity. This molding approach may also be used to provide snap action features that are circular in plan despite operating on square keys. The figure also shows interstitial pads **274** implemented with floating pucks **278** that have are made of a high durometer material **73** and then insert-molded into the molded elastomer **28,** providing an easily printed and durable surface in a one-piece flexible keypad. To provide backlighting, floating pucks **278** may made of a translucent material that continues downwards to a printed circuit board **35** with LED or lightpipe **87** lighting. LED **250** is shown in a different plane (beyond) stop **43.**

FIG. 10 shows a high durometer material **73** is located in the center **62** of key **31** and overmolded by a low durometer material **68** that includes a minimally spaced gap **69** and a snap-action tactile feature **33** that is provided by an undercut **70** that lay below the surface **34,** proximal to the associated periphery **64.** The compliance of the lower durometer material **68** allows the tool forming the undercut **70** to be removed. A foot **71** rest on printed circuit board **35.** Bosses on lower surface of keyboard, protruding within holes in printed circuit board **35,** may be used to provide lateral rigidity of the structure.

FIG. 11 shows an elastomeric IACK keyboard in which nearly the entire surface is made of a hard plastic material. A variation of FIG. 10, FIG. 11 shows the high durometer material **73** extending nearly to the edge of the key **31** and the low durometer material **68** extending below the high durometer material **73.** This provides compliance for increased contact between switch **47** and conductor **46** and provides the user additional motion after key actuation, mimicking overtravel. As above, the compliance of the lower durometer material **68** allows the tool forming the undercut **70** to be removed.

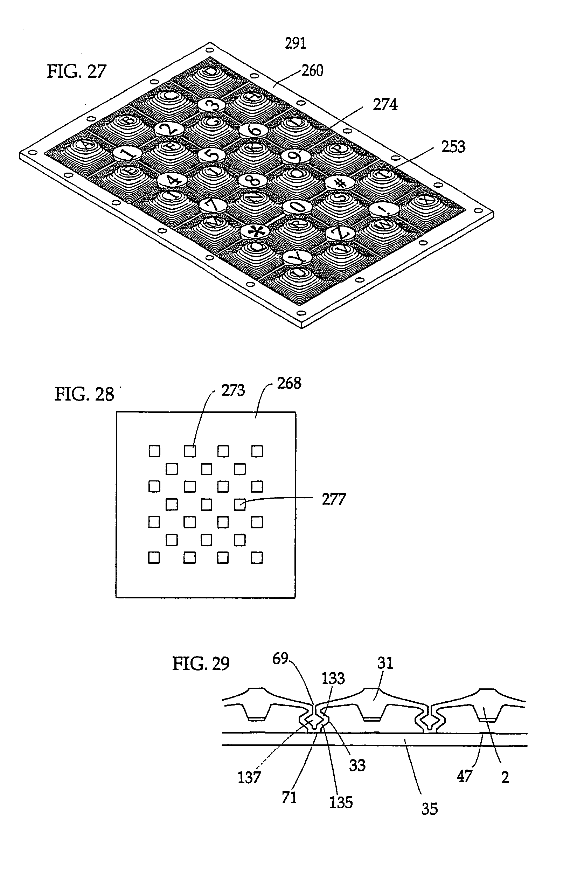

FIG. 12 shows the high durometer material **73** extending along the entire surface **34.** Low durometer material **68** acts as a foot **71** and snap-action tactile feature **33.** This figure shows how the a rigid plastic tiled keycaps **10** of FIG. 3 can be integrated with a low durometer material **68** to provide hard plastic key tops in a continuous molded device. This embodiment is not preferred as it results in a higher actuation force and/or wider gaps between keys. Lower actuation force is provided by the snap action tactile feature **33** shown in FIG 29, an improvement made at the cost of increased manufacturing concerns to achieve the flexure necessary to remove the part from the tool without damaging the elastomeric portions.

FIG. 13 shows a molded one piece continuous elastomeric tiled IACK keyboard with individually motile keys and tactile feedback in which nearly the entire surface is made of a hard plastic material with geometrically controlled key actuation. This design guides the path of the individual keys as they depress through their stroke. A key **31,** predominately of a high durometer material **73** is highly asymmetric in profile and has a pivot **76,** preferably oriented at the front of the device, closest to the user. The side of the key **31** furthest from the user connects to the pivot **76** of the adjacent key through a thin web **4** of low durometer material **68** providing snap-action tactile feature **33.** The other two sides of the key **31** connect to adjacent keys as shown in FIG 11. Conductor **46** is at a shallow angle so that after rotation about pivot **76,** it lays parallel with printed circuit board **35,** providing a well defined hard stop with high degree of surface contact at switch **47.** Shown in perspective in FIG. 21.

FIG. 14 shows utilization of up to approximately 80% of the top surface of the printed circuit board **35** for coverage with electronic componentry **80.** Switches **47** are located as dictated by the associated keyboard device, as location for interstitial pads **12.** The small geometry, location / density of materials, and additional conformal coat **48,** all discussed above, allows embodiments of the keyboard described above to have electronic componentry **80** on the top surface of printed circuit board **35,** including integrated circuits **77.** Traces for switches **47** are directed to a lower layer of the printed circuit board **35** with vias **236,** freeing the entire top surface for interconnect traces for the electronic componentry **80.** This allows the keyboard matrix to be done once correctly and then buried within the PCB, offering the exposed surface for the development of future products on exposed surfaces. Therefore, as corrections may be necessary during the development cycle, the traces will be easily accessible.

FIG. 15 shows a lightpipe **87** for tiled keyboards with interstitial keys. Interstitial pads **12** are molded from an optically transmissive material with orthogonal interconnections **88** as shown. Light originates from a source **89** enclosed in an internally reflective housing **90** and shines down orthogonal interconnections **88** to interstitial pads **12** where light is again reflected along axis of interstitial pads **12,** creating a backlight at each. The same method may be used for individual keys, by using an optically transmissive elastomer for guiding light from lightpipe **87** to the side of center **62.** Lightpipe **87** and single piece of plastic **23** may be combined into a single part.

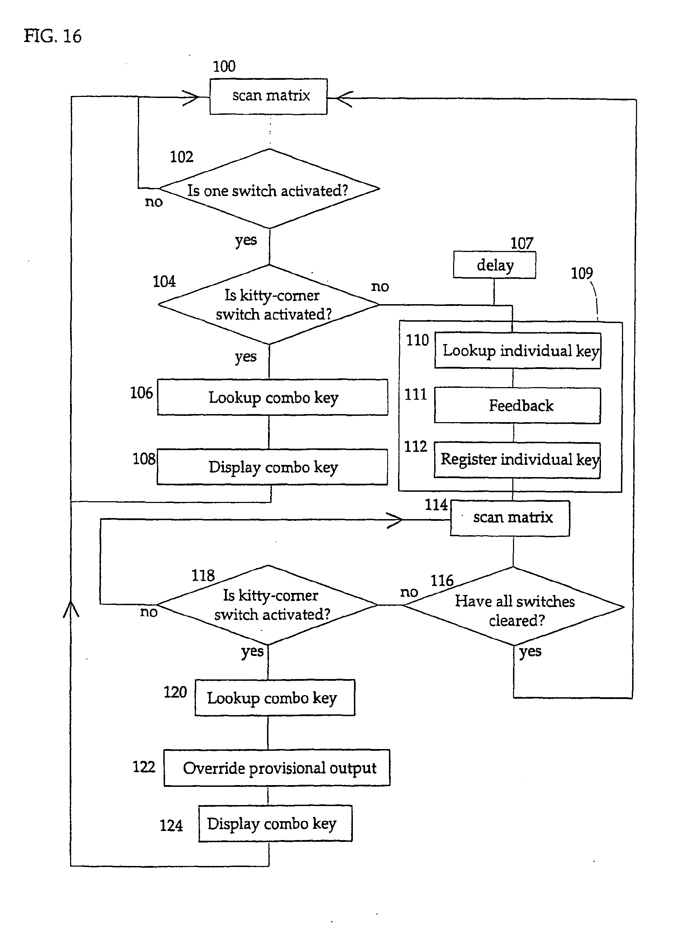

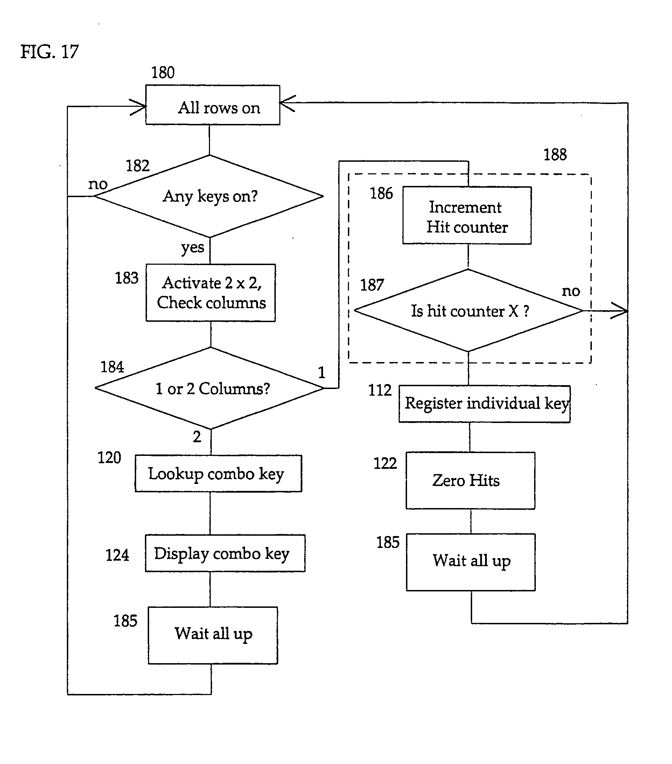

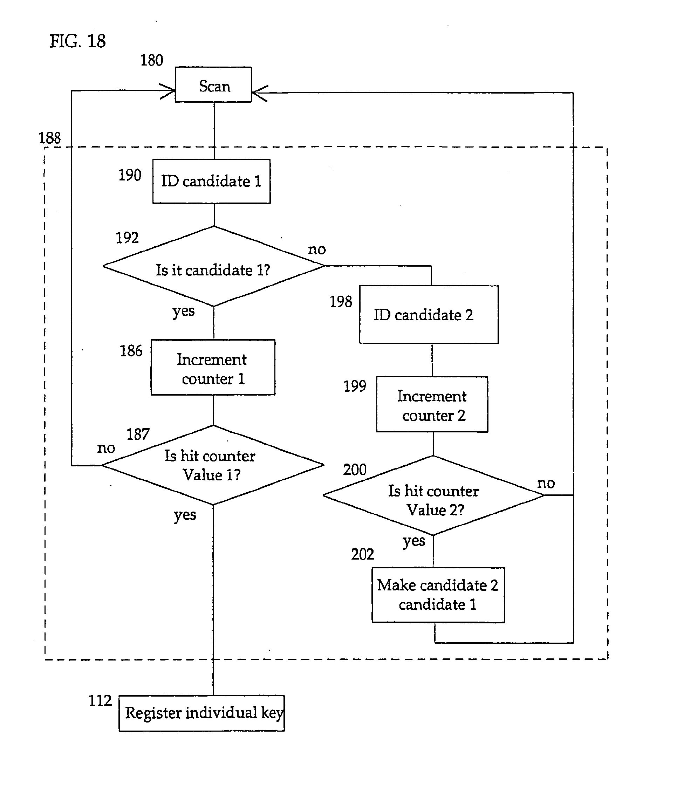

FIG. 16 shows an after-the-fact (two-layer) algorithm for determining key actuation in a tiled keyboard with interstitial keys. It increases the performance in combination of the speed of response and the accuracy of output. It may be used in conjunction with the first-stage algorithms described in FIGS 17 and 18. First-stage algorithms correlate with steps 100 through 114 of this figure. The matrix scan **100** may be a traditional search of rows and columns, or a novel approach that drives two adjacent rows simultaneously, seeking for two simultaneous output columns, thereby indicating an intended combination key output automatically. Step **102:** if no keys are activated, scanning continues. Step **104:** once one key activation is detected, the device determines if a kitty corner (diagonally adjacent) key is also activated. An additional scan is necessary if the two-adjacent-row approach is used. If the active switches indicate a combination key output is intended, step **106** looks up the desired key in an internal table and step **108** is to display the desired key. The user is provided feedback that the key has been registered. This may be audio, visual and/or tactile. If no kitty corner switch is activated in step **104,** then the device assumes that an individual key output is intended and enters step **109,** a phase of determining, provisionally, which individual key is intended. In step **109,** the provisionally determined output is looked up (step **110)** and/or stored as raw data into a register and/or the display itself (step **112).** Critical: The user is provided feedback that the key has been registered (step **111).** This feedback may be audio, visual and/or tactile. It can be useful to delay (step **107)** any or all feedback imperceptibly (approximately 50 microseconds) to allow muscular motion to continue after the provisional output is determined. This is especially true if the user is operating keys quickly with a light touch, as may be determined by measuring the time between key strokes and correlating with the details of correction after the delete key is used.

This output is provisional because a second layer of scanning (step **114)** is initiated to determine if the actuated switch becomes deactivated for a sufficient time to be considered open (step **116).** If this occurs, then the cycle returns to step **100** and repeats. If not, the device *continues to scan* for kitty corner switch activation in step **118.** This scan continues until the switches are cleared (step **116).** If a kitty corner switch is activated prior to all switches clearing, the device determines that a combination key was originally intended. The device then determines the intended combination key (step **120)** and outputs the intended combination key (step **124),** to the exclusion of the provisionally determined output (step **122).** The user is unaware that it is possible for the final output to be determined *after* he was provided feedback that the operation was registered. The number of correct hits to establish a combination output can be very small (on the order of 16 cycles at 8 Mhz) to provide accurate results. This figure does not show the wait states associated with the debouncing of each individual switch as these are well-known and understood in the art.

FIG. 17 shows another embodiment for improved determination of key actuation in an IACK keyboard. It accounts for the delays associated with the individual keys within a single combination key contacting at different times. In step **180** all rows are driven high simultaneously as step **182** searches on the columns for any switch activity. When at least one of the columns indicates an activated switch, the rows are driven in adjacent pairs (first and second, second and third, third and forth, etc.) as the columns are examined for switch activation in step **183.** A branch occurs according to whether or not one or two columns measure a high output in step **184.** If two lines are high, then the device determines which combination key is activated in step **120,** displays it in step **124** and then waits until all columns are low (step **185)** before repeating the process in step **180.** If only one column is high, then it enters the individual key analysis in step **188.** Step **188** is shown in greater detail in FIG. 18. Briefly, step **188** sets a first hit counter for keeping track of the number of cycles that the indicated key is measured as being high. Step **186** increments the counter each time. Step **187** determines if a predetermined number of counts (X) have been measured. The value of this number (value 1) is critical to proper operation. Preferred value is the equivalent of approximately 20 - 30 milliseconds. This number may also be incorporated into a learn mode. For example: Delete key usage after an individual key followed by an input of an associated combination key strongly indicates that this predetermined value should be increased. A good high-end value is approximately 50 milliseconds. In step **122** the counter is reset and in step **185** the device waits until all columns are low before repeating the process in step **180.**

FIG. 18 shows a detailed description of step **188.** This algorithm speeds the acquisition of a final key while maintaining accuracy by providing a device-level debounce. It accounts for erratic actuations due to the extreme proximity of adjacent keys. Initially, a first candidate is identified (step **190)** and the device proceeds by default through steps **192, 186** and **187.** During the second cycle options may occur. Step **192** is a branch point for each scan determining if the current scan matches the first candidate identified in step **190.** If it does, then a first counter is incremented (step **186).** If this first counter, monitoring Value 1, has reached the predetermined number of counts (step **187)** then the candidate is judged to be an intended output and the candidate key is output in step **112.** If not, the device continues to scan (step **180)** until a sufficient number of candidate measurements have been read. However, in the event that a different key stroke is identified in step **192,** (due to device level key bouncing) then a second candidate is identified in step **198** and a second counter is incremented in step **199.** If the second counter has not yet achieved a second value (Value 2), one that is significantly smaller than the fore mentioned predetermined number, (16 is a reasonable value at 8 MHz) then the cycle repeats unchanged by returning to step **180.** If the total of the second counter reaches Value 2, then candidate number one is replaced with candidate number two and the process returns to step **180,** and the process begins again.

FIG. 19 shows the most basic elastomeric embodiment of miniaturized tiled keys with interstitial output. To operate in a tiled, miniaturized keyboard, a key **31** must lie within certain geometric constraints. There must be an empty volume **132** large enough to accommodate the entire width of the finger as the central portion of the finger compresses during the act of pressing on an individual key **31,** thereby avoiding the accidental actuation of an adjacent key **2.** One way to define this parameter is to say that the keys must be volcano-shaped. Volcano-shaped is defined as having a top (elevated central pad **14)** significantly smaller than the bottom (distance across periphery **64)** and a steep initial angle of sloped sides **121.** This geometry allows reliable independent access to both individual keys **31** and to interstitial outputs (labelled by interstitial pad **12).** Another way to define the parameter is to say that the projected area of elevated central pad **14** is approximately 15 to 30% of the total projected area of the periphery **64** when both projections are made to the primary plane of the keyboard. Another way to say it is that the ratio between the height of the elevated central pad **14** as measured from the periphery **64** and the width of elevated central pad **14** cannot be too small, specifically, the ratio needs to be approximately 1:6 or more.

In the preferred embodiment, the elevated central pad **14** is between 3 to 4.5 mm across and the periphery **64** is between 7.5 to 9.5 mm across. The diameter of the interstitial pads is between 5 to 6.5 mm.The elevated central pad **14** is a rounded square **136** with radii **138.** The distance between the elevated central pad **14** and the elevation of the periphery **64** is 1.2 mm. This is approximately equal to the key stroke of 1 mm.

Extended key **150** is created by the projecting the volume of two individual keys to form a wider key. A relatively few number of extended keys **150** are used for important and/or common outputs, such as "space" or "send." The switch mechanism for extended key **150** may follow the existing pattern, or may be implemented with larger single switch.

FIG. 20 shows finger **67** is shown pressing on the elevated central pad **14** of a center key **156** and the edges **151** of the finger **67** are in compliance due to the high force localized in the region of elevated central pad **14** of center key **156.** However, due to the narrow width of central pad **14,** there is an empty volume **132** that results in finger **67** applying zero or near-zero force to the adjacent keys **155** and **157,** thereby leaving them unactivated. That is to say that the width of elevated central pads **14** is small enough to allow a full width of finger **67** to lay between the right edge **170** of the left key **155** and the left edge **171** of the right key **157.** Furthermore, the height between elevated central pad **14** and elevation of the periphery **64** must be such that after compliance of the finger edges **151** and displacement of the center key **156,** and an expected placement error of a few millimeters, a high force is not applied to either of the adjacent keys **155** and **157.** The initial slope **162** is high (from 70-90%). The balance of the intervening curve **160** is secondary in importance. As referenced above, the ratio between the width of elevated central pad **14** and the width of periphery **64** is between approximately 1:2 and 1:3.

FIG. 21 shows a perspective view of the subject matter of FIG. 13 for additional clarity.

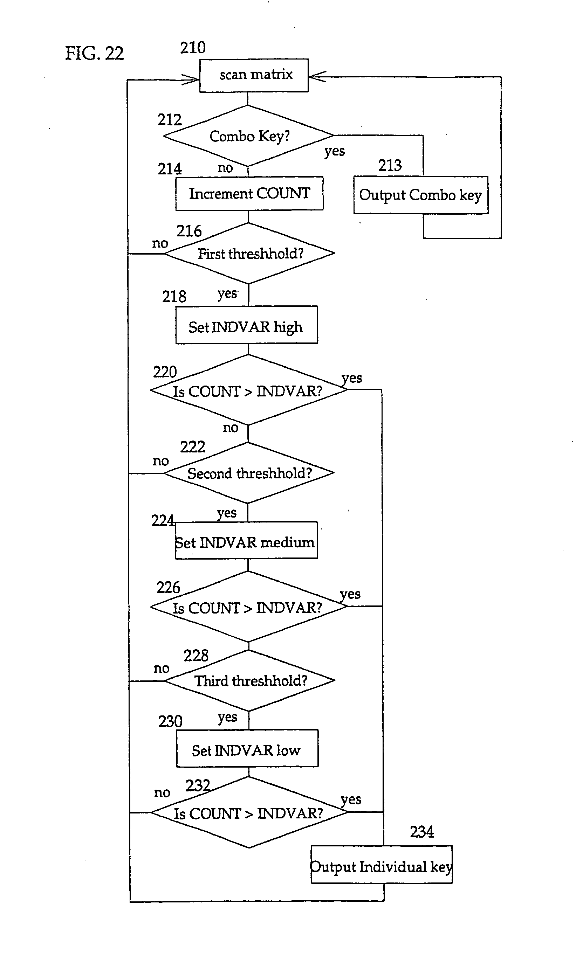

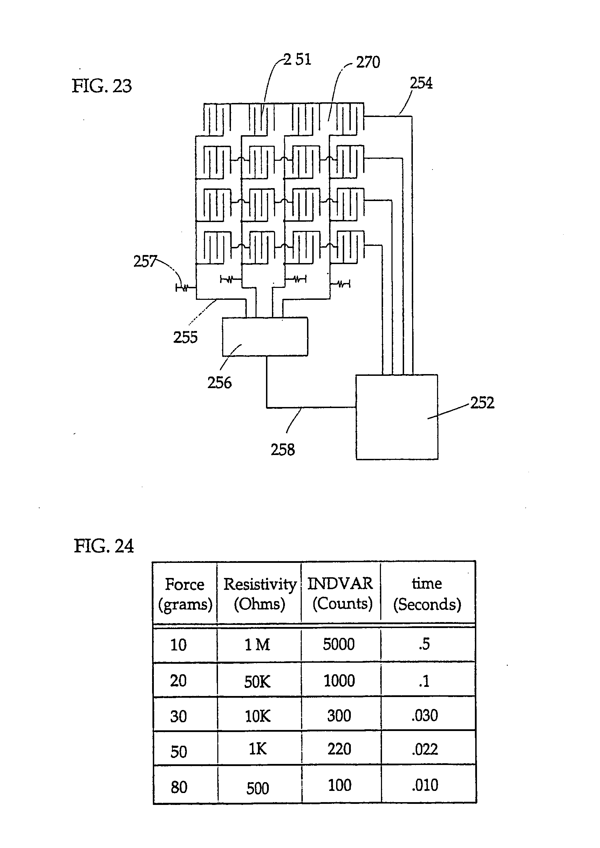

FIG. 22 shows the logic diagram for differentiating intended individual key output from combination key output as a function of key attack characteristic. A first key switch matrix **270** is scanned in step **210.** In step **212** the microprocessor **252** checks for combination keys, as described above, or with another approach. If an intended combination key is detected, the appropriate combination is output in step **213.** If not, in step **214** the counter is incremented. The counter, tallies the number of times that the microprocessor **252** records the same individual key is activated in a continuous sequence: the Count. Note: for the purposes of this explanation, I will refer to an individual key switch being evaluated to determine if it is an intended individual key as Candidate 1. In step **216** it is determined if the attack on the key switch of Candidate 1 is of a quality to warrant establishing a first threshold. (In the preferred embodiment the quality being measured is the resistivity of the switch. Other qualities, such as the speed of attack or capacitance may also be used.) If the resistivity reaches the minimal threshold, then the device continues to step **218** where the variable called INDVAR (individual key variable) is set to a "high" value from what is essentially an infinite default value. If the threshold is not reached the device returns to step **210.** INDVAR is the variable which determines the number of times that the same independent key (Candidate 1) must be registered in order to qualify as an intended output by the user. In step **220,** the Count is compared with the current setting of INDVAR. If INDVAR is exceeded by the Count, then the criteria for an intended individual key is met and Candidate 1 is output in step **234.** If not, step **222** determines if the attack on the Candidate 1 switch has met the criteria to establish a second threshold. In the preferred embodiment, this is a lower resistivity than the first threshold. (Suggested values are given in FIG. 24) If so, INDVAR is set to an intermediate value in step **224.** The process is repeated with successively lower resistivities allowing successively lower values of the Count to dictate that the microprocessor **252** output Candidate 1. The overall purpose of this procedure is to correlate the amount of time necessary to establish an intended independent key with the degree of assuredness that the user applies to the device. If the user is moving very slowly, (and pressing lightly) then the device sets itself to require a much longer period of continuously non-varying input to accept Candidate 1 as the intended output. If the user is moving quickly and with vigor (and pressing with more force) the device decreases the amount of time required (of continuously non-varying input) to accept Candidate 1 as the intended output. Because speed and force correlate in this application, the result is fast, reliable output in response to fast reliable input in an IACK keyboard.

FIG. 23 shows an electrical schematic associated with the logic diagram of FIG. 22. A first key switch matrix **270** is comprised of switches **251** that lay beneath the elevated center keys **253** of FIG. 6. The rows **254** are driven by the microprocessor **252.** The signal from the columns **255** is fed into an analog-to-digital converter **256** that in turn provides the microprocessor **252** with information about both which one of the switches **251** is activated and the resistivity of that switch through the report lines **258.** An 8-bit report line is provided. Pull up resistors **257** hold the inputs to the analog-to-digital converter **256** at a constant value when the lines are not driven. Note: In an embodiment as shown in FIG. 5, the capacitive state may be used.

FIG. 24 shows example values that may used to implement the electronics of FIG. 22. Five thresholds are shown. As an example: the first line indicates that with 10 grams of force placed on an individual key switch, the resistivity within that switch is 1 megohm. Upon receiving a report that resistivity has reached this first threshold or higher, INDVAR should be set to 5000 counts which correlates with the requirement that a continuous reading of Candidate 1 must be at least 0.5 seconds to count as an intended output. (Note: the specific INDVAR number is somewhat arbitrary as it scales with program implementation and clock speed. In FIG. 24, each cycle of the device program is completed in 0.0001 seconds.) As the force increases during the key stroke, additional thresholds are achieved and the time required to determine an individual key output is reduced accordingly.

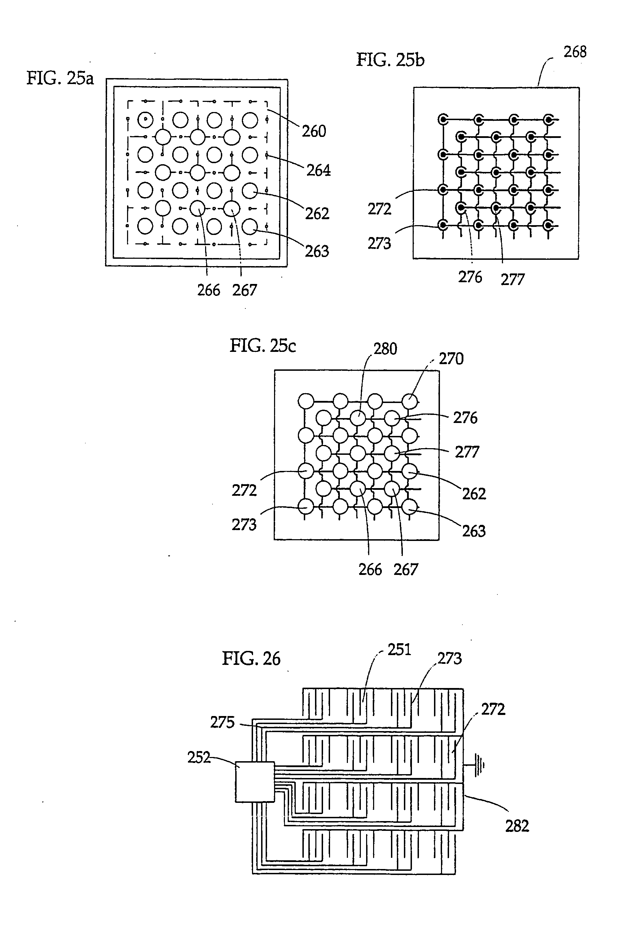

FIG. 25A shows the back side of an elastomeric IACK keyboard **260** with a matrix of 4 x 4 elevated center keys **253.** A plurality of individual key switch conductor pads **262** are disposed beneath elevated center keys **253** and together comprise a first conductor array **263.** In the preferred embodiment, individual key switch conductor pads **262** consist of silicone-based carbon-doped circular pucks insert molded into the keypad elastomer. Other switch technologies may be used. First conductor array **263** is disposed proximate to and parallel with a first contact matrix **273** (FIG 25b).

A plurality of combination key contact pads **266** are located below the interstices of associated combinations of individual keys, below interstitial pads **274** and together comprise a second conductor array **267.** The second conductor array **267** provides two functions: 1) It allows combination keys to be operable with very small objects such as pencil erasers, using as criteria: actuation of a combination key contact pad **266** OR (at minimum) either of the associated opposing diagonals of the first key switch matrix **270.** 2) It adds another piece of information that may be used to enhance the existing detection algorithms.

It is useful to have first conductor array **263** offset slightly from second conductor array **267** so that the two are out of plane from each other. In this elastomeric embodiment, nubs **264** protrude downwards and keep the conductor pads from non-intended contact with the switch contacts on printed circuit board **268.**

FIG. 25B shows the printed circuit board **268** with individual key switch contacts **272,** together comprising a first contact matrix **273.** First contact matrix **273** aligns with first conductor array **263,** together forming a first switch matrix **270.** Also shown are the combination key contacts **276** together comprising a second contact matrix **277.** Second contact matrix **277** aligns with second conductor array **267,** together forming a second switch matrix **280.** Viewing FIG. 27 momentarily, it is clear how second contact matrix **277** enables an eraser point to operate an IACK keyboard.

FIG. 25C shows first switch matrix **270** and second switch matrix **280.** First conductor array **263** and second conductor array **267** are shown disposed directly over first contact matrix **273** and second contact matrix **277.**

FIG. 26 shows a first contact matrix **273** in which one side of each switches is held at common potential, in this case ground **282.** Each individual key switch contacts **272** has a trace **275** leading to processor **252.** This architecture eliminates the timing error associated with scanning a switch matrix, as all keys are scanned simultaneously. This embodiment may be implemented as shown in FIG. 28.

FIG. 27 shows the interface surface of an elastomeric implementation of a IACK keyboard. Elastomeric keyboard **260** has interstitial pads **274** and elevated center keys **253.** The drawing shows a layout two adult human finger units wide and three adult human finger units high with 39 output functions available with a single finger press. Moreover, the number of outputs available with a single press provided in an area N adult human finger units wide and M adult human finger units high, is given by 8MN-2N-2M+1. Interstitial pads **274** may be fixed as detailed in FIG. 29.

FIG. 28 shows an embodiment of printed circuit board **268,** implemented as described in FIG. 26. first contact matrix **273** and second contact matrix **277** connect to microprocessor **252** through traces **275** located within the printed circuit board **268.** The printed circuit board **268** operates with an elastomeric keyboard **260** with a continuously conductive surface on the underside.

FIG. 29 shows molded one piece continuous elastomeric tiled keyboard with individually motile keys and tactile feedback keys. Key **31** includes snap action feature **33** which includes an upper leg **133** and a lower leg **135,** forming void **137** with the upper leg **133** and a lower leg **135** of the adjacent key 2. Void **137** is accessible through minimally spaced gap **69.** Snap action 33 may also be implemented in either or both legs **(133** and **135).** Elastomeric edges allow this embodiment to be removed from the tooling.

Following that the invention refers to a compact keypad including a first plurality of functions each one of said first plurality associated with one of a plurality of key caps and a second plurality of functions, each one of said second plurality associated with a combination of adjacent ones of said plurality of key caps, a key cap structure including:
a key cap, said key cap including a contact surface on an upper exposed side of said key cap and a periphery, said periphery to define the extent of said key cap in a primary plane, said periphery including a plurality of edges;
an elastomeric beam, a first end of said elastomeric beam disposed proximate to and parallel with at least one of said plurality of edges, here called a first edge, said first end attached to said key cap on an underside surface of said key cap, such that a ledge is created at said first edge, said ledge extending over and covering much of said elastomeric beam;
a beam terminus, said beam terminus disposed beneath said first edge, said beam terminus connected to a second end of said elastomeric beam, thereby providing said compact keypad with minimal visual gaps between adjacent ones of said plurality of edges, and a tactile feedback response in a one-piece unit,
wherein preferably at least either the horizontal or vertical on-center distances between adjacent ones of a plurality of said key caps is less than, or approximately equal to half of the width of an adult human finger,
further preferably including a legend zone disposed centrally on said contact surface, said legend zone to be elevated slightly and significantly smaller in area than half of the width of an adult human finger by half of the width of an adult human finger such as to provide said adult human finger means to exert force upon said key cap without exerting force on an adjacent one of said plurality of key caps,
wherein said ledge is preferably made of an elastomeric material and a portion of said contact surface is made of a second, relatively more rigid material,
wherein said ledge preferably additionally extends at least partially over said beam terminus and
wherein said beam terminus preferably constrains the path of travel of an adjacent key cap.

The invention also refers to an improvement in a compact keyboard system with a first plurality of functions output as a consequence of the activation of one of a plurality of independent key switch means and a second plurality of functions output as a consequence of the near-simultaneous activation of adjacent ones of plurality of independent key switch means; and control electronics wherein said improvement includes:
a force measurement means that monitors a force level imposed on each one of said plurality of independent key switch means,
further preferably including a legend zone disposed centrally on said key cap, said legend zone to be elevated slightly and significantly smaller in area than half of the width of an adult human finger by half of the width of an adult human finger such as to provide said adult human finger means to exert force upon said key cap without exerting force on an adjacent one of said plurality of key caps wherein at least either the horizontal or vertical on-center distances between adjacent ones of a plurality of said key caps is less than, or approximately equal to half of the width of an adult human finger and
wherein said force measurement means preferably measures the attack rate of a finger of a user, and consequently varies the amount of time said compact keyboard system will delay, from the instant a given signal is first established, a determination of whether or not said control electronics will accept an input from one of a plurality of independent key switch means and subsequently output one of said first plurality of functions.

The invention futher refers to a compact keypad including a first plurality of functions, each one of said first plurality associated with one of a plurality of key caps, and a second plurality of functions each one of said second plurality associated with combinations of adjacent ones of said plurality of key caps, a keypad structure including:
a plurality of legend zones disposed centrally within each of said first plurality of key caps, each of said plurality of legend zones to be elevated slightly and significantly smaller in area than half of the width of an adult human finger by half of the width of an adult human finger such as to provide said adult human finger means to exert force upon one of said plurality of key caps without exerting force on an adjacent one or ones of said plurality of key caps;
an elastomeric web, said web to include a matrix of molded-in edges that together define said plurality of keycaps;
a base surface, said base surface disposed beneath said plurality of key caps to support said elastomeric web;
a boundary structure portion of said elastomeric web disposed approximately beneath said matrix, said boundary structure portion extending perpendicular to a primary plane of said elastomeric web, and towards said base surface, yet without contacting said base surface at such time when said key caps are in a rest position;
a base foot portion of said elastomeric web, said base foot disposed beneath ones of said plurality of key caps, proximate to yet off-axis to said boundary structure such that said boundary structure portion may move toward said base surface, said base foot to remain in contact with said base surface;
an elastomeric beam including an over-center, snap-action feature, said elastomeric beam disposed between said base foot and said boundary structure, thereby providing tactile feedback to a user as ones of said plurality of key caps are pressed,
wherein said elastomeric web preferably includes at least two hardnesses of material, a harder material disposed in a central region of each of said plurality of key caps and a softer material in the remaining portion and
further preferably including a travel limiting structure, said travel limiting structure disposed below said boundary structure, the dimension of said travel limiting structure

The invention even further refers to a compact keypad including:
a first plurality of functions each one of said first plurality associated with one of a plurality of key caps, said keycaps provided motility from an elastomeric first material;
a second plurality of functions, each one of said second plurality associated with a combination of adjacent ones of said plurality of key caps;
a first plurality of legend zones disposed centrally on each one of said plurality of key caps, each one of said first plurality of legend zones to be elevated slightly and significantly smaller in area than half of the width of an adult human finger by half of the width of an adult human finger such as to provide said adult human finger means to exert force upon said key cap without exerting force on an adjacent one of said plurality of key caps; and
a second plurality of legend zones, said second plurality of legend zones disposed at the interstices of adjacent ones of said plurality of key caps wherein each one of said second plurality of legend zones is made of a second material, said second material of a significantly higher durometer than said first material
wherein said second plurality of legend zones are preferably comprised of a single, continuous piece of material.

## Claims

1. A method for increasing the speed of response and the accuracy of output in an IACK keypad system, the method comprising:
scanning (100) a matrix to determine (102) if any keys have been activated;
upon detecting activation of a key, identifying (109) a provisional independent key output;
continuing to scan (114) for key activation; and,
upon detecting (118) activation of a diagonally adjacent key prior to determining that all switches have cleared, determining (120) an intended combination key, overriding the provisional output (122) and outputting (124) the intended combination key.

2. The method of claim 1 including, upon detecting activation of a key, determining (104) if a diagonally adjacent key is activated and, upon determining that no diagonally adjacent key is activated, identifying (109) the provisional independent key output.

3. The method of claim 1 including, upon determining (116) that all switches have cleared, again scanning the matrix (100) to determine (102) if any keys have been activated.

4. The method of claim 1 further comprising, upon detecting an activated diagonally adjacent key, looking up (106) an associated combination key output and displaying (108) said combination key output.

5. The method of claim 1 comprising, upon determining that no diagonally adjacent key is activated, providing (111) feedback that the activated key has been registered.

6. The method of claim 5 wherein the feedback comprises audio, visual and/or tactile feedback.

7. The method of claim 5 wherein the feedback is provided (111) before continuing to scan (114) for key activation.

8. The method of claim 1 wherein the provisional independent key output is stored (112) into a register and/or a display.

9. The method of claim 1 further comprising delaying (107) feedback of the provisional independent key output to allow muscular motion to continue after the provisional output is determined.

10. The method of claim 9 wherein the feedback is delayed approximately 50 milliseconds.

11. An electronic device with an IACK keypad having an exposed surface defining both independent key regions and combination key regions, and adapted to perform the method of claim 1.
